# EUROPEAN PATENT APPLICATION

(11) **EP 2 706 577 A1**
(43) Date of publication of application: **12.03.2014**
(21) Application number: 12796125.8
(22) Date of filing: 08.06.2012
(51) Int. Cl.: H01L 31/04, C01B 19/00

(54) **APPLICATION LIQUID FOR FORMING LIGHT-ABSORBING LAYER, AND METHOD FOR PRODUCING APPLICATION LIQUID FOR FORMING LIGHT-ABSORBING LAYER**

(30) Priority: 10.06.2011 US 201113157923
(71) Applicant: Tokyo Ohka Kogyo Co., Ltd., Kanagawa 211-0012 (JP)
(72) Inventor: KUWAHARA Masaru, Kawasaki-shi, Kanagawa 211-0012 (JP); MISUMI Koichi, Kawasaki-shi, Kanagawa 211-0012 (JP); MIYAMOTO Hidenori, Kawasaki-shi, Kanagawa 211-0012 (JP)
(74) Representative: Cabinet Plasseraud
(86) International application number: PCT/JP2012/064813
(87) International publication number: WO 2012/169621

(57) **Abstract**

A coating solution for forming a light-absorbing layer of a CZTS solar cell, including a hydrazine-coordinated Cu chalcogenide complex component (A), a hydrazine-coordinated Sn chalcogenide complex component (B) and a hydrazine-coordinated Zn chalcogenide complex component (C) dissolved in dimethylsulfoxide.

## Description

### TECHNICAL FIELD

The present invention relates to a coating solution for forming a light-absorbing layer, and a method for producing the coating solution.

Priority is claimed on U.S. Patent Application No. 13/157,923, the content of which is incorporated herein by reference.

### BACKGROUND ART

In recent years, in consideration of environment, solar cells have been attracting a growing interest. In particular, attention has been drawn to chalcopyrite solar cells which are thin-film solar cells with high photoelectric conversion efficiency, and also CZTS solar cells which have a rare metal such as indium used in a chalcopyrite solar cell substituted with another element, and hence, research and development have been actively conducted.

A chalcopyrite solar cell is produced by forming a light absorbing layer prepared from a chalcopyrite material on a substrate. Representative elements of a chalcopyrite material include copper (Cu), indium (In), galium (Ga), selenium (Se) and sulfur (S), and representative examples of a light absorbing layer include Cu(In, Ga)Se₂ and Cu(In, Ga)(Se, S)₂, which are abbreviated as CIGS and CIGSS, respectively. Recently, CZTS solar cell has been studied in which a rare metal indium has been substituted and is composed of, for example, copper (Cu), zinc (Zn), tin (Sn), selenium (Se) and sulfur (S). Representative examples of the light absorbing layer of such a solar cell include Cu₂ZnSnSe₄, Cu₂ZnSnS₄ and Cu₂ZnSn(S, Se)₄.

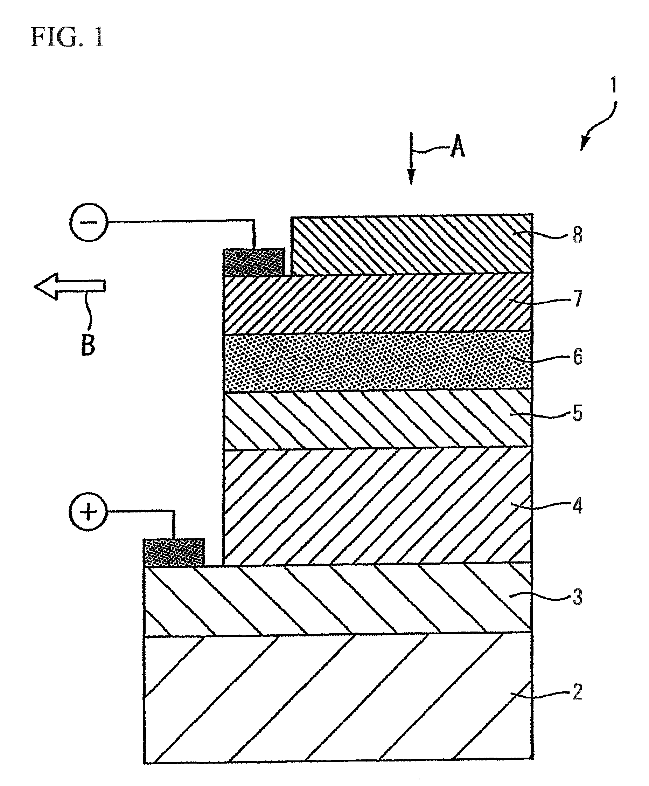

FIG. 1 is a schematic cross-sectional diagram of an example of a chalcopyrite solar cell or a CZTS solar cell.

As shown in FIG. 1, a chalcopyrite solar cell or a CZTS solar cell 1 has a basic structure in which a first electrode 3, a CIGS or CZTS layer 4, a buffer layer 5, an i-ZnO layer 6 and a second electrode 7 are laminated on a substrate 2 in this order. As the buffer layer, for example, a CdS layer, an ZnS layer and an InS layer are known.

Each of the first electrode 3 and the second electrode 7 has a terminal connected thereto, and each of the terminals is connected to a wiring. In such a chalcopyrite solar cell or a CZTS solar cell 1, an incident light entering in the direction of A is absorbed by the CIGS or CZTS layer 4 to generate an electromotive force, and an electric current flows in the direction of B.

The surface of the second electrode 7 is, for example, covered with an anti-reflection film layer 8 composed of an MgF₂ layer for protection.

As a method of forming a CIGS or CZTS layer 4, a sputtering method and a coating method are known. However, in the sputtering method, the size of the apparatus tends to be scaled up, thereby deteriorating the yield. Therefore, diligent studies have been made on the coating method which enables production at a relatively low cost.

Generally, in a coating method, elements such as Cu, In, Ga, Se and S are dissolved in a specific solvent to prepare a coating solution, and the coating solution is applied to a substrate by a spin coating method or a dipping method, followed by baking, thereby forming a CIGS layer (see for example, Patent Document 1 and Patent Document 2).

In the preparation of a coating solution, there are known a method in which hydrazine is used as the solvent, and a method in which amine is added as a dissolution promoter instead of using hydrazine.

### DOCUMENTS OF RELATED ART

### [Patent Document]

[Patent Document 1] U.S. Patent No. 7,094,651
[Patent Document 2] U.S. Patent No. 7,517,718

### SUMMARY OF THE INVENTION

### [Problems to be Solved by the Invention]

However, in the preparation of a coating solution, when hydrazine is used as the solvent, a problem has conventionally been raised in terms of safety of the process due to chemical properties (explosiveness) of hydrazine.

Further, since the coating solution is a metal-dispersed coating solution, a problem arose in terms of storage stability. In addition, for maintaining the metal dispersion, particular consideration is necessary in the coating apparatus, and the freedom of choice of the apparatus was restricted.

In view of these problems, there have been demands for a coating solution which can assure safety of process and have storage stability over a long time. However, such a coating solution has not been proposed under these circumstances.

### [Means to Solve the Problems]

For solving the above-mentioned problems, the present invention employs the following embodiments.

The coating solution of the present invention is used for forming a light-absorbing layer of a CZTS solar cell, and includes a hydrazine-coordinated Cu chalcogenide complex component (A), a hydrazine-coordinated Sn chalcogenide complex component (B) and a hydrazine-coordinated Zn chalcogenide complex component (C) dissolved in dimethylsulfoxide.

Further, the method of producing a coating solution according to the present invention is a method of producing a coating solution used for forming a light-absorbing layer a CZTS solar cell, and includes preparing dimethylsulfoxide having a hydrazine-coordinated Cu chalcogenide complex dissolved therein as a first solution, dissolving a hydrazine-coordinated Sn chalcogenide complex in dimethylsulfoxide to obtain a second solution, dissolving a hydrazine-coordinated Zn chalcogenide complex in dimethylsulfoxide to obtain a third solution, and mixing together the first solution, the second solution and the third solution.

### [Effect of the Invention]

In the present invention, since Cu, Sn and Zn are dissolved in not hydrazine but dimethylsulfoxide (DMSO), there is no need to use dangerous hydrazine in the application of the coating solution. As a result, safety of the process in the formation of a light-absorbing layer can be assured. Further, in the coating solution for forming a light-absorbing layer according to the present invention, since hydrazine-coordinated metal chalcogenide complexes are uniformly dissolved in the solution, storage stability is increased, and the freedom of the choice of the coating apparatus is improved.

### BRIEF DESCRIPTION OF THE DRAWINGS

FIG. 1 is a schematic cross-sectional diagram of an example of a chalcopyrite solar cell or a CZTS solar cell.
FIG. 2 is the results of X-ray diffraction analysis following formation of a film in Example 1.
FIG. 3 is the results of X-ray diffraction analysis following formation of a film in Example 2.
FIG. 4 is a cross-sectional diagram of the CZTS layer formed in Example 2 as measured by a scanning electron microscope.

### DETAILED DESCRIPTION OF THE INVENTION

Hereinbelow, the coating solution for forming a light-absorbing layer according to the present invention will be described.

The coating solution of the present embodiment which is used for forming a light-absorbing layer of a CZTS solar cell is obtained by dissolving a hydrazine-coordinated Cu chalcogenide complex component (A), a hydrazine-coordinated Sn chalcogenide complex component (B) and a hydrazine-coordinated Zn chalcogenide complex component (C) in dimethylsulfoxide (DMSO).

The coating solution for forming a light-absorbing layer is preferably free of amine solvents.

The hydrazine-coordinated Cu chalcogenide complex component (A) can be obtained, for example, by dissolving a Cu metal and a chalcogen in DMSO having hydrazine added thereto, and adding a poor solvent to the resulting solution, followed by recrystallization.

More specifically, a Cu metal and a chalcogen are reacted in DMSO in the presence of hydrazine, and stirred at room temperature for about 3 to 7 days. Then, hydrazine is removed from the resulting solution while flowing nitrogen, followed by filtration. Thereafter, a poor solvent is added to the filtrate to perform a recrystallization, thereby obtaining a black hydrazine-coordinated Cu chalcogenide complex.

Alternatively, the hydrazine-coordinated Cu chalcogenide complex component (A) can be obtained by reacting a metal Cu and a chalcogen in dimethylsulfoxide in the presence of hydrazine, followed by concentration and filtration.

More specifically, a metal Cu and 2 to 4 equivalents of Se are stirred in DMSO at room temperature for 3 days to 1 week in the presence of 2 equivalents of hydrazine relative to the Cu metal. Then, the remaining hydrazine is removed under reduced pressure, followed by concentration. The resulting concentrated solution is subjected to filtration, thereby obtaining a hydrazine-coordinated Cu-Se complex/DMSO solution.

As the chalcogen, Se or S can be used, and Se is preferable. As Cu, not only a Cu metal, but also copper selenide (Cu₂Se) may be used. As the poor solvent, an alcohol solvent is preferable, and isopropanol (IPA) is more preferable.

As hydrazine, anhydrous hydrazine may be used, although hydrazine monohydrate or hydrazine having water added thereto (hereafter, referred to as "water-containing hydrazine") is preferable. Anhydrous hydrazine vigorously reacts with selenium, whereas hydrazine monohydrate or a water-containing hydrazine mildly reacts with selenium. Therefore, hydrazine monohydrate or a water-containing hydrazine is preferable in terms of ease in handling in the synthesis process. The water content of the water-containing hydrazine is preferably 63% by weight or more.

With respect to the amount of Cu and the chalcogen, it is preferable to use 2 to 4 mol of the chalcogen, per 1 mol of Cu. Further, it is preferable to dissolve Cu and the chalcogen in DMSO having about 2 mol of hydrazine added thereto.

The generation of the hydrazine-coordinated Cu chalcogenide complex described above can be expressed by a chemical formula (1) shown below.

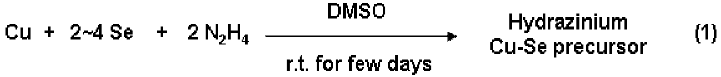

Next, the hydrazine-coordinated Sn chalcogenide complex component (B) will be described. The hydrazine-coordinated Sn chalcogenide complex component (B) used in this embodiment is required to be generated so as to be soluble in DMSO. The hydrazine-coordinated Sn chalcogenide complex can be generated, for example, by adding Sn metal and a chalcogen in hydrazine to obtain a crude product, extracting the crude product with DMSO, adding a poor solvent to the resulting solution, followed by reprecipitation.

More specifically, Sn metal and a chalcogen are added to hydrazine, and stirred at room temperature for about 1 to 3 days. Then, hydrazine is removed from the resulting solution while flowing nitrogen to obtain a crude product. Thereafter, the obtained crude product is extracted with DMSO.

Subsequently, the extraction solution obtained by extracting the crude product is subjected to filtration using, for example, a 0.2 µm PTFE filter, followed by concentration. Then, a poor solvent is added to the concentrated solution to perform a reprecipitation, and the supernatant is removed. The precipitate is washed with IPA and dried, thereby obtaining a dark-yellow hydrazine-coordinated Sn chalcogenide complex.

Alternatively, the hydrazine-coordinated Sn chalcogenide complex component (B) can be prepared as follows. A metal Sn and 3 equivalents of Se are stirred in hydrazine (5 ml) at room temperature for 1 to 3 days. Then, IPA is added and stirred, and a yellow product is precipitated. The supernatant is removed, and the precipitate is washed with IPA and dried, thereby obtaining a crude product.

Subsequently, the crude product is subjected to extraction with DMSO (80°C, 1 hr), followed by concentration. The resulting concentrated solution is subjected to filtration, thereby obtaining a hydrazine-coordinated Sn-Se complex/DMSO solution.

The generation of the hydrazine-coordinated Sn chalcogenide complex described above can be expressed by a chemical formula (2) shown below.

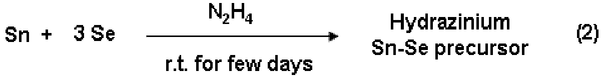

As the chalcogen, Se or S can be used, and Se is preferable. As Sn, not only a Sn metal, bu also Sn selenide (SnSe, SnSe₂) may be used. As the poor solvent, an alcohol solvent is preferable, and IPA is more preferable. As hydrazine, anhydrous hydrazine may be used, although hydrazine monohydrate or a water-containing hydrazine is preferable. With respect to the amount of Sn and the chalcogen, it is preferable to use 3 mol of the chalcogen, per 1 mol of Sn.

Next, the hydrazine-coordinated Zn chalcogenide complex will be described. The hydrazine-coordinated Zn chalcogenide complex used in this embodiment is required to be generated so as to be soluble in DMSO. The hydrazine-coordinated Zn chalcogenide complex can be generated, for example, by mixing Zn or ZnSe and a chalcogen in the presence of hydrazine to obtain a crude product, followed by extracting the crude product with dimethylsulfoxide.

More specifically, Zn selenide and a chalcogen are added to hydrazine in DMSO, and stirred at room temperature for about 3 to 7 days. Then, hydrazine is removed from the resulting solution while flowing nitrogen to obtain a crude product (reaction intermediate solution). Thereafter, the obtained crude product is extracted with DMSO.

Subsequently, the extraction solution obtained by extracting the crude product is subjected to filtration using, for example, a 0.2 µm PTFE filter, followed by concentration. The resulting concentrated solution is subjected to filtration, thereby obtaining a hydrazine-coordinated Zn chalcogenide complex.

The generation of the hydrazine-coordinated Zn chalcogenide complex described above can be expressed by a chemical formula (3) shown below.

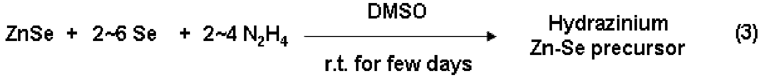

As the chalcogen, Se or S can be used, and Se is preferable. As Zn, not only Zn selenide, but also Zn metal may be used. As hydrazine, anhydrous hydrazine may be used, although hydrazine monohydrate or a water-containing hydrazine is preferable. Further, as the reaction solvent, hydrazine may be used instead of DMSO. With respect to the amount of Zn selenide (ZnSe) and the chalcogen, it is preferable to use 2 mol or more of the chalcogen, per 1 mol of Zn selenide, and it is more preferable to use 3 to 4 mol of the chalcogen, per 1 mol of Zn selenide.

Further, in the coating solution for forming a light-absorbing layer according to the present invention, for increasing the grain size, it is preferable to add a hydrazine-coordinated Sb chalcogenide complex.

A hydrazine-coordinated Sb chalcogenide complex can be obtained, for example, by adding Sb selenide (Sb₂Se₃) and a chalcogen to hydrazine to obtain a crude product, extracting the crude product with DMSO, and adding a poor solvent to the resulting solution to perform recrystallization.

More specifically, Sb selenide and a chalcogen are added to hydrazine, and stirred at room temperature for about 3 to 7 days. Then, hydrazine is removed from the resulting solution while flowing nitrogen to obtain a crude product. Thereafter, the obtained crude product is extracted with DMSO.

Subsequently, the extraction solution obtained by extracting the crude product is subjected to filtration using, for example, a 0.2 µm PTFE filter. Then, a poor solvent is added to the filtrate for reprecipitation, thereby obtaining a black hydrazine-coordinated Sb chalcogenide complex.

The generation of the hydrazine-coordinated Sb chalcogenide complex described above can be expressed by a chemical formula (4) shown below.

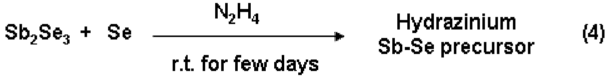

As the chalcogen, Se or S can be used, and Se is preferable. As the poor solvent, an alcohol solvent is preferable, and IPA is more preferable. As hydrazine, anhydrous hydrazine may be used, although hydrazine monohydrate or a water-containing hydrazine is preferable. With respect to the amount of Sb selenide (Sb₂Se₃) and the chalcogen, it is preferable to use 2 mol or more of the chalcogen, per 1 mol of Sb selenide.

Although the present embodiment is described using Sb selenide, an elemental antimony may also be used instead of Sb selenide. In such a case, with respect to the amount of antimony (Sb) and the chalcogen, it is preferable to use 4 mol or more of the chalcogen, per 1 mol of antimony.

Next, the method of producing the coating solution for forming a light-absorbing layer will be described.

Firstly, DMSO is added to the aforementioned hydrazine-coordinated Cu chalcogenide complex and stirred at room temperature for about one night, thereby obtaining a DMSO solution having the hydrazine-coordinated Cu chalcogenide complex dissolved therein (first solution).

Further, DMSO is added to the aforementioned hydrazine-coordinated Sn chalcogenide complex and stirred at a temperature of 80 to 120°C for about 1 hour, thereby obtaining a DMSO solution having the hydrazine-coordinated Sn chalcogenide complex dissolved therein (second solution).

Further, DMSO is added to the aforementioned hydrazine-coordinated Zn chalcogenide complex and stirred at a temperature of 80 to 120°C for about 1 hour, thereby obtaining a DMSO solution having the hydrazine-coordinated Zn chalcogenide complex dissolved therein (third solution).

If desired, DMSO is added to the aforementioned hydrazine-coordinated Sb chalcogenide complex, and stirred at room temperature for one night, thereby obtaining a DMSO solution having the hydrazine-coordinated Sb chalcogenide complex dissolved therein (fourth solution).

In addition, if desired, 2 equivalents of Se is added to Na₂Se, and stirred in DMSO at room temperature for 3 to 7 days, thereby obtaining a uniform solution.

In the present embodiment, Na is used for improving the film quality of the light-absorbing layer (e.g., grain size and crystalline quality), and this Na solution may not be used.

Subsequently, the DMSO solution having the hydrazine-coordinated Cu chalcogenide complex dissolved therein, the DMSO solution having the hydrazine-coordinated Sn chalcogenide complex dissolved therein and the DMSO solution having the hydrazine-coordinated Zn chalcogenide complex dissolved therein are mixed together.

In this manner, the coating solution for forming a light-absorbing layer according to the present embodiment can be produced.

The coating solution for forming a light-absorbing layer according to the present embodiment may have the aforementioned fourth solution added thereto. Further, the coating solution for forming a light-absorbing layer according to the present embodiment may have the aforementioned Na solution added thereto.

The coating solution for forming a light-absorbing layer according to the present embodiment uses DMSO as the solvent, and the coating solution itself does not contain hydrazine. As a result, the chemical properties (explosiveness) of hydrazine in the formation of a light-absorbing layer would not be of any problems, thereby improving the safety of the production process.

Further, since hydrazine-coordinated metal chalcogenide complexes are uniformly dissolved in the solution, storage stability is increased, and the freedom of the choice of the coating apparatus is improved.

Furthermore, the coating solution for forming a light-absorbing layer according to the present embodiment contains no amines as a dissolution promoter. When amines are used as a dissolution promoter, the amines remain in the device after formation of the film, thereby deteriorating the PV (photovoltaic) performance.

In the coating solution for forming a light-absorbing layer according to the present embodiment, if desired, a miscible additive may be included as long as the effects of the present invention are not impaired, for example, an organic solvent for adjusting the viscosity, an additive resin for improving the performance of the film, a surfactant for improving the applicability or a stabilizer.

Next, a method of producing a CZTS solar cell according to the present embodiment will be described.

The method of producing a CZTS solar cell according to the present embodiment mainly includes the steps of forming a first electrode on a substrate, forming a light-absorbing layer on the first electrode, forming a buffer layer on the light-absorbing layer, and forming a second electrode on the buffer layer.

In the method, the steps other than the step of forming a light-absorbing layer on the first electrode can be performed by any conventional method. For example, the step of forming a first electrode on a substrate can be performed by a sputtering method using nitrogen as a sputtering gas, and forming a film layer such as an Mo layer. The buffer layer can be formed as a CdS layer by, for example, a chemical bath deposition method. The second electrode can be formed as a transparent electrode using an appropriate material.

In the formation of a light-absorbing layer, firstly, the aforementioned coating solution for forming a light-absorbing layer is applied to the first electrode (support). The application of the coating solution can be conducted by a spin-coat method, a dip-coat method, a doctor-blade (applicator) method, a curtain-slit cast method, a printing method, a spraying method or the like.

The application conditions can be appropriately selected depending on the desired film thickness, concentration of the materials and the like.

For example, in a spin-coating method, the support is set on a spin coater, followed by applying the coating solution to the support. The application conditions can be appropriately selected depending on the film thickness. For example, the application can be performed at a rotation speed of 300 to 3,000 rpm for 10 to 60 seconds.

In a dipping method, the support can be dipped in a container containing the coating solution. The dipping can be performed once, or a plurality of times.

After applying the coating solution for forming a light-absorbing layer on the support, a vacuum drying may be performed.

Subsequently, after applying the coating solution on the support, the support is baked to form a light-absorbing layer.

The baking conditions can be appropriately selected depending on the desired film thickness, the type of materials used, and the like. For example, the baking can be performed in 2 steps, namely, performing a soft bake on a hot plate (prebake), followed by baking in an oven (annealing).

In such a case, for example, the support may be set and held on a hot plate, followed by raising the temperature of the hot plate to 100 to 400°C to perform the soft bake for 1 to 30 minutes. Then, the inside of the oven can be heated to 300 to 600°C, and maintained for 1 to 180 minutes to perform the annealing.

As a result, the light-absorbing layer is cured.

The baking temperatures described above are merely one example of the baking conditions, and the baking conditions are not particularly limited. For example, the temperature of the hot plate can be raised in a stepwise manner, and the heating may be performed in an inert gas atmosphere in a glove box.

Thereafter, the film thickness of the light-absorbing layer is measured. When the film thickness is smaller than the desired thickness, the coating solution for forming a light-absorbing layer is applied to the support again and baked. By repeating these steps, a light-absorbing layer having the desired thickness can be obtained.

In the manner as described above, a CZTS solar cell according to the present embodiment can be produced. Since the CZTS solar cell produced by the method of the present embodiment contains no hydrazine in the coating solution, the safety of the production process can be improved. Further, since the coating solution for forming a light-absorbing layer exhibits improved storage stability, limitation on the production process can be reduced.

Hereinabove, the present invention has been explained based on the aforementioned embodiments. Needless to say, the present invention is not limited to the aforementioned embodiments, and various modifications can be made without departing from the spirit or scope of the present invention.

For example, in the aforementioned embodiments, although the hydrazine-coordinated Cu chalcogenide complex is obtained by dissolving Cu and a chalcogen in DMSO having hydrazine added thereto, and adding a poor solvent to the resulting solution for recrystallization, the present invention is not limited thereto, and any hydrazine-coordinated Cu chalcogenide complex may be used. It would be satisfactory as long as DMSO having a hydrazine-coordinated Cu chalcogenide complex dissolved therein is ultimately prepared. For example, Cu and a chalcogen may be dissolved in DMSO having hydrazine dissolved therein, and the remaining hydrazine may be removed, so as to use the resulting solution.

Nevertheless, the hydrazine-coordinated Cu chalcogenide complex described in the aforementioned embodiments exhibits excellent solubility in DMSO. Therefore, by using this complex, a coating solution for forming a light-absorbing layer with a high precision can be obtained as compared to the conventional methods.

### EXAMPLES

As follows is a description of examples of the present invention, although the scope of the present invention is by no way limited by these examples.

### (Example 1)

In Example 1, a coating solution for forming a light-absorbing layer was produced as follows.

A metal Cu (383.0 mg, 6.03 mmol) and 2 to 4 equivalents of Se (4 equivalents: 1903.2 mg, 24.10 mmol) were stirred in DMSO (10 ml) at room temperature for 3 days to 1 week in the presence of 2 equivalents of hydrazine relative to the Cu metal (378 µl, 12.05 mmol). Then, the remaining hydrazine was removed by flowing nitrogen, followed by filtration using a 0.2 µm PTFE filter.

Thereafter, IPA (total of 20 ml) was gradually added to the filtrate to perform recrystallization, thereby obtaining a black hydrazine-coordinated Cu-Se chalcogenide complex (2,424 mg).

Separately from the above, a metal Sn (356 mg, 3.00 mmol) and 3 equivalents of Se (711mg, 9.00mmol) were stirred in hydrazine (5 ml) at room temperature for 1 to 3 days. Then, the remaining hydrazine was removed by flowing nitrogen, thereby obtaining a crude product. The crude product was extracted with DMSO (80°C, 1 hr), followed by filtering the extraction liquid using a 0.2 µm PTFE filter. Subsequently, IPA was added and stirred, thereby precipitating a dark-red product. Then, supernatant was removed, and the precipitate was washed with IPA and dried, thereby obtaining a dark-yellow hydrazine-coordinated Sn-Se chalcogenide complex (1,016 mg).

Separately from the above, zinc selenide (ZnSe, 460 mg, 4.02 mmol) and 2 to 6 equivalents of Se (5 equivalents: 1,588 mg, 20.11 mmol) were stirred in DMSO (8 ml) at room temperature for 3 days to 1 week in the presence of 2 to 4 equivalents of hydrazine relative to ZnSe (3 equivalents: 12.07 mmol). Then, the remaining hydrazine was removed by flowing nitrogen, thereby obtaining a reaction intermediate solution. Subsequently, the reaction intermediate solution was extracted with DMSO at room temperature or under heated conditions (heated condition: 80°C, 1 hr). Then, the extracted liquid was subjected to filtration using a 0.2 µm PTFE filter, followed by concentration under reduced pressure. The obtained concentrated solution was filtered, thereby obtaining a hydrazine-coordinated Zn precursor solution.

Subsequently, the hydrazine-coordinated Cu-Se complex, the hydrazine-coordinated Sn-Se complex and the hydrazine-coordinated Zn-Se complex were individually dissolved in DMSO to obtain a hydrazine-coordinated Cu-Se complex/DMSO solution (concentration: 78.4 mg/ml in terms of Cu₂Se) (hereafter, referred to as "solution A"), a hydrazine-coordinated Sn-Se complex/DMSO solution (concentration: 178.2 mg/ml in terms of SnSe₂) (hereafter, referred to as "solution B") and a hydrazine-coordinated Zn-Se complex/DMSO solution (concentration: 12.4 mg/ml in terms of ZnSe) (hereafter, referred to as "solution C"), respectively.

Thereafter, the solution A (1.904 ml), the solution B (1.255 ml) and the solution C (14.400 ml) were mixed together to prepare a CZTS/DMSO precursor solution.

Application of the coating solution was performed by a dipping method, and the baking was performed by conducting a soft bake on a hot plate at 300°C for 1 minute, followed by closing the hot plate with a lid to perform annealing at 540°C for 10 minutes.

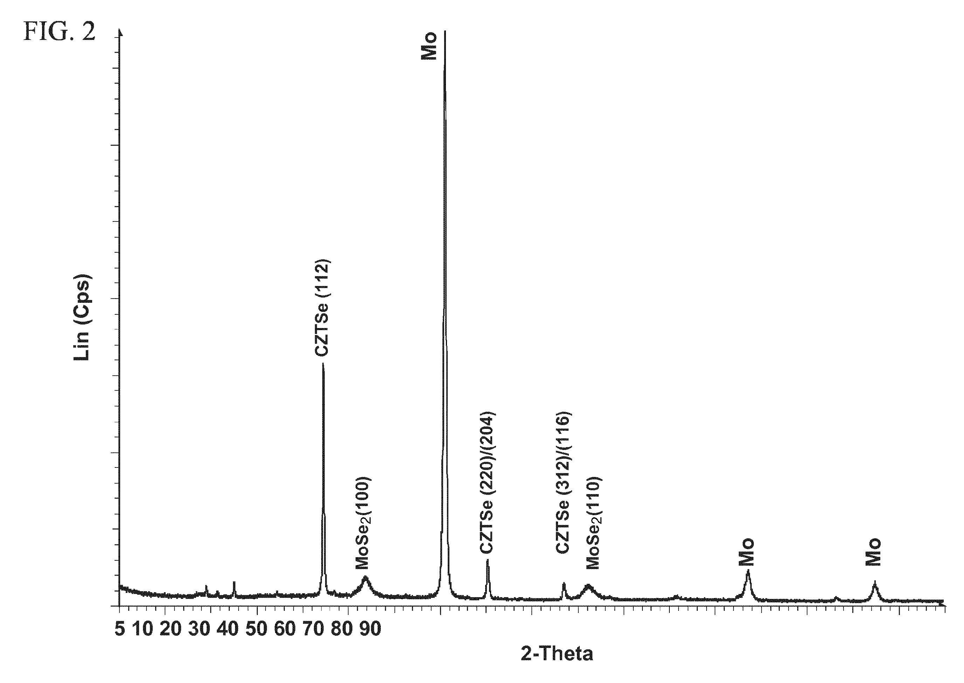

The results of X-ray diffraction analysis (XRD) following formation of the film is shown in FIG. 2.

At about 2θ = 27°, 45° and 53 to 54°, significant peaks ascribed to CZTS on (112) plane, (220)/(204) plane and (312)/(116) plane were observed, respectively. These results showed good consistency with the XRD analysis results reported in vacuum methods such as a sputtering method ((R. A. Wibowo et al., Journal of Physics and Chemistry of Solids, 68, 1908-1913 (2007))) and a simultaneous deposition method (G. S. Babu et al, Journal of Physics D: Applied Physics, 41, 205305 (2008) and G. S. Babu et al, Semiconductor Science and Technology, 23, 085023 (2008)). Thus, it was confirmed that a CZTS film was formed.

### (Example 2)

A hydrazine-coordinated Cu-Se complex, a hydrazine-coordinated Sn-Se complex and a hydrazine-coordinated Zn-Se complex were obtained in the same manner as in Example 1. Subsequently, the hydrazine-coordinated Cu-Se complex, the hydrazine-coordinated Sn-Se complex and the hydrazine-coordinated Zn-Se complex were individually dissolved in DMSO to obtain a hydrazine-coordinated Cu-Se complex/DMSO solution (concentration: 76.3 mg/ml in terms of Cu₂Se) (hereafter, referred to as "solution D"), a hydrazine-coordinated Sn-Se complex/DMSO solution (concentration: 98.4 mg/ml in terms of SnSe₂) (hereafter, referred to as "solution E") and a hydrazine-coordinated Zn-Se complex/DMSO solution (concentration: 15.9 mg/ml in terms of ZnSe) (hereafter, referred to as "solution F"), respectively.

Subsequently, the solution D (4.412 ml), the solution E (5.00 ml) and the solution F (14.084 ml) were mixed together to obtain a CZTS/DMSO precursor solution (a) (6.95 mg/ml of solid content remaining after baking of 300°C/1 min + 500°C/5 min).

15 ml of the obtained CZTS/DMSO precursor solution (a) was collected, and distilled to remove the solvent, thereby obtaining a CZTS solid mixture. Then, 5 ml of DMSO was added to the CZTS solid mixture, thereby obtaining a concentrated CZTS/DMSO solution (solid content of 100.40 mg/ml remaining after baking of 300°C/1 min + 500°C/5 min).

Application of the coating solution was performed by a spin-coat method, and the baking was performed by conducting a soft bake on a hot plate at 375°C for 1 minute, followed by closing the hot plate with a lid to perform annealing at 540°C for 10 minutes.

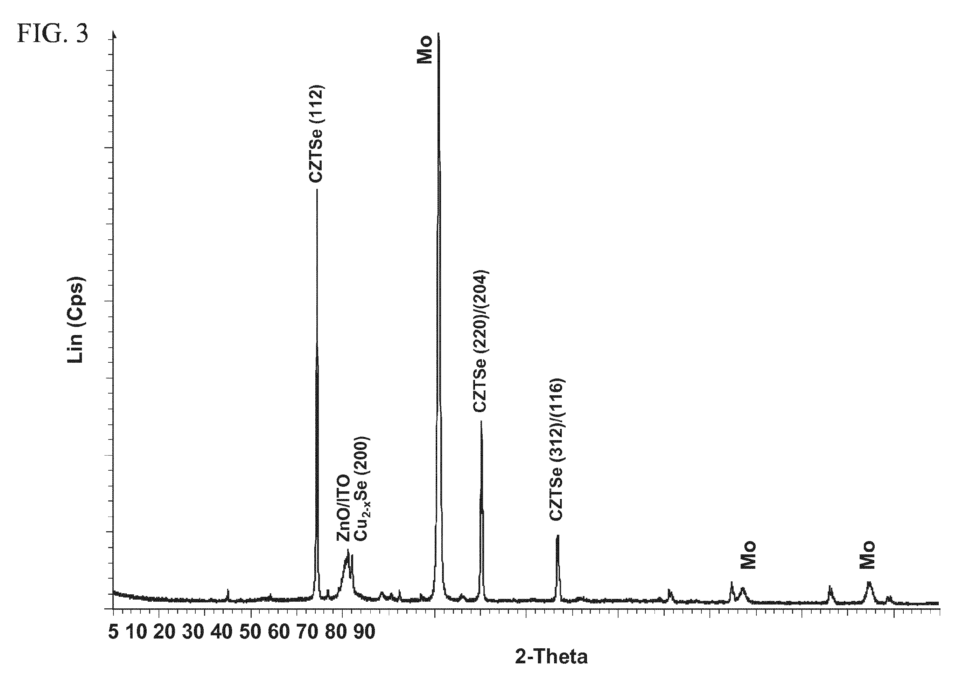

The results of X-ray diffraction analysis (XRD) following formation of the film is shown in FIG. 3.

Like in Example 1, at about 2θ = 27°, 45° and 53 to 54°, significant peaks ascribed to CZTS on (112) plane, (220)/(204) plane and (312)/(116) plane were observed, respectively. These results showed good consistency with the XRD analysis results reported in vacuum methods such as a sputtering method ((R. A. Wibowo et al., Journal of Physics and Chemistry of Solids, 68, 1908-1913 (2007))) and a simultaneous deposition method (G. S. Babu et al, Journal of Physics D: Applied Physics, 41, 205305 (2008) and G. S. Babu et al, Semiconductor Science and Technology, 23, 085023 (2008)). Thus, it was confirmed that a CZTS film was formed.

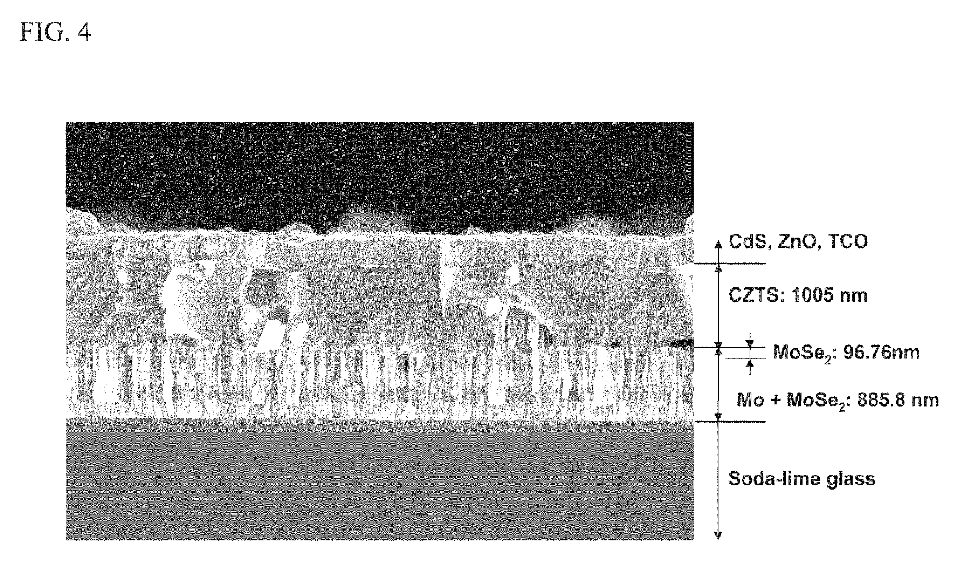

Further, after the formation of the CZTS film, a CdS layer was formed by a chemical bath deposition (CBD) method, and a ZnO layer and a transparent electrode layer (ITO) were formed thereon by a sputtering method. The cross-sectional diagram of the obtained film taken by a scanning electron microscope (SEM) is shown in FIG. 4.

### (Example 3)

A hydrazine-coordinated Cu-Se complex, a hydrazine-coordinated Sn-Se complex and a hydrazine-coordinated Zn-Se complex were obtained in the same manner as in Example 1. Then, the hydrazine-coordinated Cu-Se complex, the hydrazine-coordinated Sn-Se complex and the hydrazine-coordinated Zn-Se complex were dissolved in DMSO to prepare a coating solution for forming a light-absorbing layer.

The coating solution was prepared so as to have a mixing ratio of Cu/(Zn + Sn) = 0.81 and Zn/Sn = 1.22.

Application of the coating solution was performed by a spin-coating method, and the baking was performed by conducting a soft bake at 325°C for 1 minute, followed by annealing at 459°C for 10 minutes.

A solar cell was produced so that an Mo layer, a CZTS layer (light-absorbing layer), a CdS layer, a ZnO layer, an ITO layer, an Ni-Al layer and an MgF2 layer were laminated on a substrate in this order.

The results of the device evaluation of the produced solar cell are shown in Table 1.

**[Table 1]**

| Conversion efficiency (%) | FF(%) | Voc (mV) | Jsc (mA/cm2) | Rs (Ω) | Rsh (Ω) |
|---|---|---|---|---|---|
| 2.30 | 44.0 | 258.0 | 20.3 | 9.5 | 110.5 |

In Table 1, "FF" indicates the fill factor, which is a value obtained by dividing the maximum power of the solar cell by (open circuit voltage x short-circuit current). Voc indicates the open circuit voltage, which is the voltage obtained when the terminal is opened during irradiation of light, i.e., the maximum voltage of the solar cell. Jsc indicates the short-circuit current, which is the current obtained when the terminal is short-circuited during irradiation of light, i.e., the maximum current of the solar cell. Rs indicates the series resistance, and Rsh indicates the shunt resistance.

From the results shown in Table 1, it was confirmed that the solar cell produced using the coating solution of the present invention exhibited excellent properties.

In the present invention, since Cu, Sn and Zn are dissolved in not hydrazine but dimethylsulfoxide (DMSO), there is no need to use dangerous hydrazine in the application of the coating solution. As a result, safety of the process in the formation of a light-absorbing layer can be assured. Further, in the coating solution for forming a light-absorbing layer according to the present invention, since hydrazine-coordinated metal chalcogenide complexes are uniformly dissolved in the solution, storage stability is increased, and the freedom of the choice of the coating apparatus is improved. Therefore, the present invention is extremely useful in industry.

### [Description of Reference Symbols]

1: Solar cell
2: Substrate
3: First electrode
4: CZTS layer (light absorbing layer)
5: Buffer layer
6: i-ZnO layer
7: Second electrode

## Claims

1. A coating solution for forming a light-absorbing layer of a CZTS solar cell, comprising a hydrazine-coordinated Cu chalcogenide complex component (A), a hydrazine-coordinated Sn chalcogenide complex component (B) and a hydrazine-coordinated Zn chalcogenide complex component (C) dissolved in dimethylsulfoxide.

2. The coating solution according to Claim 1, which is free of amine solvents.

3. The coating solution according to Claim 1 or 2, wherein the hydrazine-coordinated Cu chalcogenide complex component (A) is obtained by reacting Cu or Cu₂Se and a chalcogen in dimethylsulfoxide in the presence of hydrazine, and adding a poor solvent to the resulting solution or subjecting the resulting solution to concentration and filtration.

4. The coating solution according to any one of Claims 1 to 3, wherein the hydrazine-coordinated Sn chalcogenide complex component (B) is obtained by adding a chalcogen and at least one of Sn, SnSe and SnSe₂ to hydrazine to obtain a crude product, and extracting the crude product with dimethylsulfoxide.

5. The coating solution according to any one of Claims 1 to 4, wherein the hydrazine-coordinated Zn chalcogenide complex component (C) is obtained by mixing Zn or ZnSe and a chalcogen in the presence of hydrazine to obtain a crude product, and extracting the crude product with dimethylsulfoxide.

6. The coating solution according to Claim 3, wherein the poor solvent is an alcohol solvent.

7. The coating solution according to any one of Claims 3 to 6, wherein the chalcogen is sulfur or selenium.

8. A method of producing a coating solution for forming a light-absorbing layer of a chalcopyrite solar cell or a CZTS solar cell, comprising:
preparing dimethylsulfoxide having a hydrazine-coordinated Cu chalcogenide complex dissolved therein as a first solution,
dissolving a hydrazine-coordinated Sn chalcogenide complex in dimethylsulfoxide to obtain a second solution,
dissolving a hydrazine-coordinated Zn chalcogenide complex in dimethylsulfoxide to obtain a third solution, and
mixing together the first solution, the second solution and the third solution.

9. The method according to Claim 8, wherein the hydrazine-coordinated Cu chalcogenide complex is obtained by reacting Cu or Cu₂Se and a chalcogen in dimethylsulfoxide in the presence of hydrazine, and adding a poor solvent to the resulting solution or subjecting the resulting solution to concentration and filtration.

10. The method according to Claim 8 or 9, wherein the hydrazine-coordinated Sn chalcogenide complex is obtained by adding a chalcogen and at least one of Sn, SnSe and SnSe₂ to hydrazine to obtain a crude product, and extracting the crude product with dimethylsulfoxide.

11. The method according to any one of Claims 8 to 10, wherein the hydrazine-coordinated Zn chalcogenide complex is obtained by mixing Zn or ZnSe and a chalcogen in the presence of hydrazine to obtain a crude product, and extracting the crude product with dimethylsulfoxide.

12. The method according to Claim 9, wherein the poor solvent is an alcohol solvent.

13. The method according to any one of Claims 9 to 12, wherein the chalcogen is sulfur or selenium.
